Europäisches Patentamt

European Patent Office

Office européen des brevets

(11) Veröffentlichungsnummer : **0 088 916**
**B1**

(12) **EUROPÄISCHE PATENTSCHRIFT**

(45) Veröffentlichungstag der Patentschrift :
21.11.85

(51) Int. Cl.⁴ : **G 01 R 31/28**

(21) Anmeldenummer : 83101774.4

(22) Anmeldetag : 23.02.83

(54) Schaltungsanordnung zum Prüfen von elektrischen, insbesondere elektronischen Einrichtungen.

(30) Priorität : 15.03.82 CH 1608/82

(43) Veröffentlichungstag der Anmeldung :
21.09.83 Patentblatt 83/38

(45) Bekanntmachung des Hinweises auf die Patenterteilung : 21.11.85 Patentblatt 85/47

(84) Benannte Vertragsstaaten :
CH DE LI NL

(56) Entgegenhaltungen :
DE-A- 2 812 344
US-A- 4 300 207
ELEKTRONIK, Band 28, Nr. 20, Oktober 1979, München, M. ZIMMER "Testen schneller Analog/Digital-Umsetzer mit Tischrechnern", Seiten 61-66
COMPUTER DESIGN, Band 20, Nr. 11, November 1981, Winchester, M.P. ZOCCOLI et al. "Rapid bus multiprocessor system", Seiten 189-200

(73) Patentinhaber : SIEMENS-ALBIS AKTIENGESELL-SCHAFT
EGA1/Verträge und Patente Postfach
CH-8047 Zürich (CH)
CH LI
Siemens Aktiengesellschaft
Berlin und München Wittelsbacherplatz 2
D-8000 München 2 (DE)
DE NL

(72) Erfinder : Goldstein, Peter
In der Ey 45
CH-8047 Zürich (CH)
Erfinder : Hofmann, Franz
Margaretenplatz 2
D-8000 München 70 (DE)

## Beschreibung

Die vorliegende Erfindung betrifft eine Schaltungsanordnung gemäss dem Oberbegriff des Patentanspruches 1.

Die Prüfung elektrischer, insbesondere elektronischer Einrichtungen in Echtzeit erfordert in vielen Fällen Testgeräte mit hoher Testablaufgeschwindigkeit. Beispielsweise beim Prüfen von PCM 30/32-Einrichtungen müssen jeweils in einem Zyklus von 125 μsec 32 ε-bit Prüfworte aufgearbeitet, dem Prüfling zugeführt und darüber hinaus noch 32 vom Prüfling abgegebene Signale empfangen und analysiert werden. Bei bekannten Anordnungen werden für Aufbereitung und Analyse der Testsignale üblicherweise ultraschnelle und daher kostspielige Rechner oder Mehrrechnersysteme eingesetzt. Sofern auf das Erfordernis einer Prüfung in Echtzeit verzichtet werden kann, genügt ein verhältnismässig langsamer Rechner, so dass der Prüfvorgang mit einer gegenüber der Arbeitsgeschwindigkeit des Prüflings wesentlich kleineren Geschwindigkeit abläuft. Eine Prüfung ist jedoch um so aussagekräftiger, je besser die Bedingungen des Testablaufes mit demjenigen eines normalen Arbeitsablaufes übereinstimmen.

Eine weitere mögliche Lösung besteht darin, die Prüfworte mit dem Rechner vor dem eigentlichen Prüfvorgang aufgrund eines Prüfprogrammes zu generieren, in einem Arbeitsspeicher abzuspeichem und mittels eines externen Taktgebers dem Prüfling mit dessen Arbeitsgeschwindigkeit zuzuführen. Der Datenaustausch erfolgt hierbei über ein Signalleitungen aufweisendes Bussystem, an das Rechner, Speicher und weitere Einheiten angeschlossen sind. Wenn eine hohe Uebertragungsgeschwindigkeit verarbeitet werden muss, wie dies wie erwähnt beispielsweise beim Prüfen von PCM 30/32-Einrichtungen zutrifft, ist die Belastung des Bussystems infolge der häufigen Belegung durch den extern gesteuerten Prüfvorgang äusserst hoch. Dadurch hat der Rechner während eines Prüfvorganges kaum die Möglichkeit, das Bussystem zu belegen, so dass er während dieser Zeit für andere Aufgaben nur beschränkt eingesetzt werden kann. Zudem ist bei einer solchen Lösung eine aufwendige Ueberwachungseinrichtung erforderlich, die die einzelnen Signalleitungen des Bussystems nach Prioritätskriterien entweder dem Rechner oder der mit dem Taktgeber ausgerüsteten Schreib-/ Leselogik zuteilt.

Eine Schaltungsanordnung der eingangs erwähnten Art ist beispielsweise aus Electronik, Bd. 28, Nr. 20, Okt., 1979, S. 61-66 bekannt, wo ein erstes bidirektionales Bussystem beschrieben ist, der über ein zweites undirektionales Bussystem Daten einem Messobjekt zuführt und dem über ein drittes undirektionales Bussystem Daten vom Messobjekt zugeführt werden. Diese Schaltungsanordnung erlaubt es, mit einem extremen Unterschied zwischen der Arbeitsgeschwindigkeit des Rechners und derjenigen eines Umsetzers zu arbeiten.

Die der Erfindung zugrundeliegende Aufgabe besteht darin, mit möglichst einfachen Mitteln eine Schalfungsanordnung gemäss dem Oberbegriff des Patentanspruches 1 zu schaffen, die eine uneingeschränkte Ausnützung der Rechnerleistung auch während eines Prüfablaufes ermöglicht.

Diese Aufgabe wird gemäss dem kennzeichnenden Teil des Patentanspruches 1 mit einer Schaltungsanordnung gelöst, bei der in vorteilhafter Weise der Prüfling wöllig vom Rechner entkoppelt ist, und zwar bei Einsatz von nur zwei Bussystemen.

Im folgenden wird die Erfindung anhand einer Zeichnung beispielsweise näher erläutert. Es zeigt :

Figur 1 das Blockschaltbild einer erfindungsgemässen Schaltungsanordnung,

Figur 2 das Blockschaltbild einer Bustrenneinrichtung.

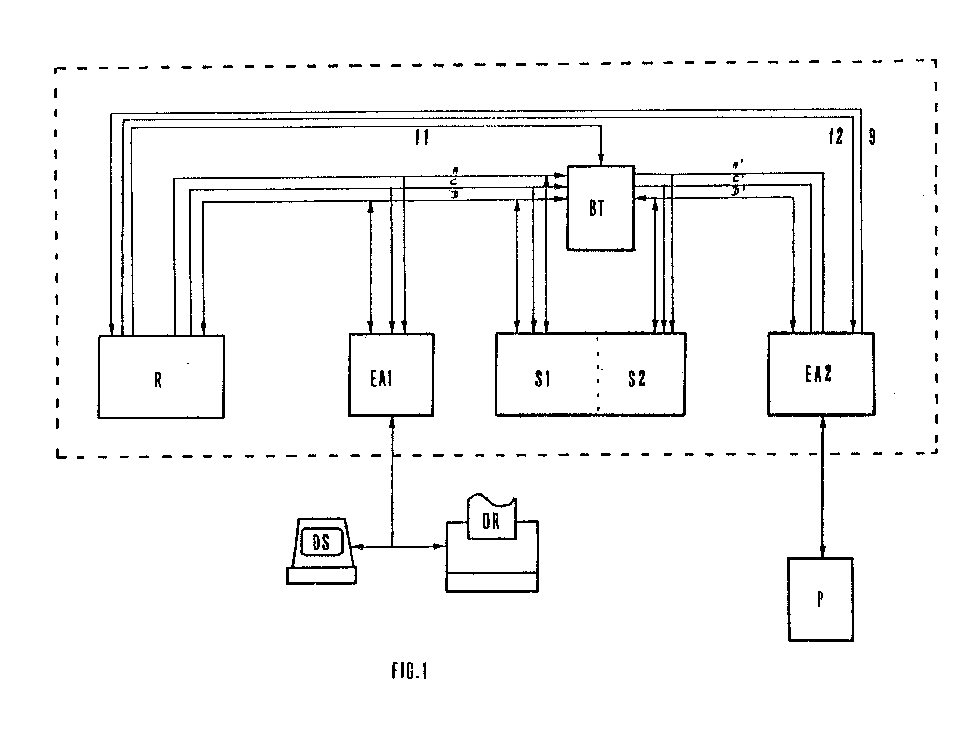

In Fig. 1 ist eine erfindungsgemässe Schaltungsanordnung schematisch dargestellt. Diese enthält ein erstes Bussystem ACD, an dem ein Rechner R sowie eine mit peripheren Einheiten — beispielsweise mit einem eine Eingabetastatur aufweisenden Datensichtgerät DS und einem Drucker DR — verbundene und als Schnittstelle zu diesen dienende erste Eingabe-/Ausgabeeinheit EA1 sowie ein erster Speicher S1 angeschlossen sind. Das erste Bussystem ACD führt über eine Bustrenneinrichtung BT zu einem zweiten Bussystem A′ C′ D′, an welches ein zweiter Speicher S2 und eine zweite mit dem jeweiligen Prüfling P verbundene und als Schnittstelle zu diesem dienende Eingabe-/Ausgabeeinheit EA2 angeschlossen ist. Vom Recher R führt eine Steuerleitung f1 zur Bustrenneinrichtung BT und eine weitere Steuerleitung f2 zur zweiten Eingabe-/Ausgabeeinheit EA2. Schliesslich ist noch eine Rückmeldungsleitung g vorhanden, die die zweite Steuereinheit EA2 mit dem Rechner R verbindet. Die Steuerleitung f2 sowie die Rückmeldungsleitung g sind ausserhalb der Bussysteme ACD bzw. A′C′D′ geführt, da die entsprechenden Signale auch dann übertragen werden müssen, wenn die Bussysteme ACD und A′C′D′ entkoppelt sind. Die in der Figur 1 eingezeichneten Pfeile zeigen die Richtung des Informationsflusses.

Im Rechner R, der mit einem handelsüblichen Mikroprozessor ausgerüstel ist, werden aufgrund eines Prüfprogrammes die Prüfworte für den folgenden Prüfvorgang erzeugt und im ersten Speicher S1 abgespeichert. Wenn von der zweiten Eingabe-/Ausgabeeinheit EA2 über die Leitung g ein Prüfendesignal gesendet wird, gibt der Rechner R über die Leitung f1 einen Durchschaltebefehl an die Bustrenneinrichtung BT. Im zweiten Speicher S2 vorhandene Prüfdaten werden zu Analysezwecken über die Bussysteme A′C′D′ und ACD in den Rechner übertragen. Vor Beginn eines Prüfablaufes werden die vorbereiteten Prüfsignale auf den zweiten Speicher S2 übertragen. Im Anschluss daran erteilt der Rechner R über die Leitung f1 einen Trennbefehl an die Bustrenneinrichtung BT und die beiden Bussysteme ACD und A'C'D' werden getrennt. Infolgedessen hat die zweite Eingabe-/Ausgabeeinheit EA2 den Speicher S2 über das zweite Bussystem A'C'D' für den Testablauf frei zur Verfügung. Auf einen vom Rechner R über die Leitung f2 abgegebenen Startimpuls wird der eigentliche Prüfablauf eingeleitet, bei dem die zweite Eingabe-/Ausgabeeinheit EA2 die im zweiten Speicher S2 abgespeicherten Prüfsignale liest, sie zum Prüfling P überträgt und die vom Prüfling P abgegebenen Prüfadaten in den zweiten Speicher S2 schreibt.

Dadurch, dass die beiden Bussysteme ACD und A'C'D' trennbar sind, wird zudem erreicht, dass das mit dem Rechner R verbundene Bussystem ACD ersterem zur freien Verfügung steht und somit während eines Testablaufes für beliebige, gegebenenfalls auch vom Prüfvorgang unabhängige Aufgaben eingesetzt werden kann.

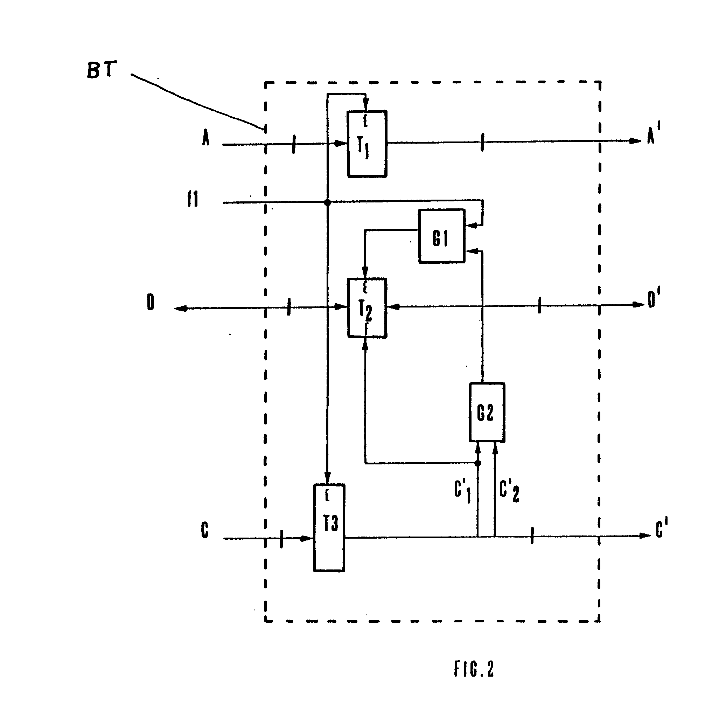

In Fig. 2 ist der Aufbau einer Bustrenneinrichtung BT beispielsweise dargestellt. Die Bussysteme ACD bzw. A'C'D' sind in als Bus bezeichnete Leitungsgruppen unterteilt. Je nach Signalart ist eine Leitung einem Adressbuss A bzw. A', einem Steuerbus C bzw. C' oder einem Datenbus D bzw. D' zugeordnet. Ein Bustreiber T1 — wobei unter « Bustreiber » signalverstärkende Elemente verstanden werden — verbindet den Adressbus A des ersten Bussystems ACD mit dem Adressbus A' des zweiten Bussystems A'C'D'. Ein Bustreiber T2 verbindet den Datenbus D des ersten Bussystems ACD mit dem Datenbus D'des zweiten Bussystems A'C'D' und ein Bustreiber T3 verbindet den Steuerbus C des ersten Bussystems ACD mit dem Steuerbus C' des zweiten Bussystems A'C'D'. Beim Adressbus A und beim Steuerbus C erfolgt der Informationsfluss nur in einer Richtung (unidirektional). Beim Datenbus D bzw. D' erfolgt der Informationsfluss in beiden Richtungen (bidirektional). Der Bustreiber T2 ist deshalb für bidirektionalen Betrieb ausgelegt und weist einen Steuereingang F auf, über welchen die Richtung des Informationsflusses wählbar ist. Diese wird bestimmt durch den Zustand der im Steuerbus C' enthaltenen, Schreibbefehle übertragenden Busleitung C1'.

Die Bustreiber T1, T2 und T3 weisen zum Trennen bzw. Verbinden der beiden Bussysteme ACD bzw. A'C'D' je einen Steuereingang E auf. Die Steuereingänge E der Bustreiber T1 und T3 sind direkt, derjenige des Bustreibers T2 über eine UND-Verknüpfung G1 mit einer Steuerleitung f1 verbunden. Der andere Eingang der UND-Verknüpfung G1 ist mit dem Ausgang einer ODER-Verknüpfung G2 verbunden, an deren Eingängen die Steuerbusleitung C1' und eine ebenfalls im Steuerbus C' enthaltene, Lesebefehle übertragende Steuerbusleitung C1' und eine ebenfalls im Steuerbus C' enthaltene, Lesebefehle übertragende Steuerbusleitung C2' angeschlossen sind. Der Bustreiber T2 ist demzufolge nur durchgeschaltet, wenn einerseits ein Durchschaltesignal auf der Steuerleitung f1 und andererseits ein Schreib- oder Lesesignal auf dem Steuerbus C' des Speichers vorliegt. Dadurch, dass der Bustreiber T2 nur während der effektiven Zeit eines Lese- oder Schreibvorganges durchschaltbar ist, wird erreicht, dass die Ausgänge in den Zeitabschnitten zwischen einem Lese- oder einem Schreibvorgang hochohmig sind. Auf diese Weise können Einschwingvorgänge besser beherrscht werden, als wenn der Bustreiber T2 direkt von einer Durchlassrichtung in die andere umgeschaltet würde. Obwohl die Schreib- oder Lesebefehle des Rechners auf den Steuerbusleitungen C1' bzw. C2' als Durchschaltekriterien für die Bustrenneinrichtung BT dienen, ist dennoch zusätzlich ein eigentlicher Durchschaltebefehl des Rechners R erforderlich, da auf den Steuerbusleitungen C1' und C2' auch Schreib- bzw. Lesebefehle der zweiten Eingabe-/Ausgabeeinheit EA2 übertragen werden. Diese Befehle würden über die ODER-Verknüfung G2 ebenfalls eine Verbindung des ersten Bussystems ACD mit dem zweiten Bussystem A'C'D' bewirken, und zwar gerade dann, wenn der Rechner R und die zweite Eingabe-/Ausgabeeinheit EA2 getrennt arbeiten sollten. Eine gegenseitige Störung wäre dann unvermeidlich.

Auf eine Darstellung des Aufbaus der Eingabe-/Ausgabeeinheit EA2 wird verzichtet. Sie hat lediglich die Aufgabe, Prüfsignale aus dem Speicher S2 auszulesen und zum Prüfling zu senden sowie die vom Prüfling abgegebenen Prüfsignale zu empfangen und in den Speicher S2 zu schreiben. Der Aufbau derartiger Eingabe-/Ausgabeeinheiten wird als bekannt vorausgesetzt. Sie können mit kombinatorischen Schaltungen oder mit Zählern und programmierbaren Festwertspeichern aufgebaut werden. Im letzteren Fall sind die Befehle (insbesondere Schreib- und Lesebefehle) im Festwertspeicher gespeichert und werden mittels eines Zählers adressiert, der durch einen internen oder auch einen externen — beispielsweise im Prüfling enthaltenen — Taktgeber und durch ebenfalls im Festwertspeicher S2 gespeicherte Steuersignale gesteuert wird.

**Patentansprüche**

1. Schaltungsanordnung zum Prüfen elektrischer, insbesondere elektronischer Geräte, mit einem Rechner (R), der aufgrund eines Prüfprogrammes Prüfworte erzeugt, die dem jeweiligen Prüfling (P) zugeführt werden, wobei die vom Prüfling (P) abgegebenen Signale über eine Eingabe-/Ausgabeeinheit an den Rechner (R) zur Auswerfung geleitet werden, und mit einem Bussystem (ACD), an dem der Rechner (R) sowie ein Speicher (S1) angeschlossen sind, dadurchgekennzeichnet, dass eine weitere mit einem oder mehreren peripheren Geräten verbundene Eingabe-/Ausgabeeinheit (EA1) an diesem Bussystem (ACD) anschliessbar ist, ferner dass ein zweites Bussystem (A'C'D') vorhanden ist, an dem ein zweiter Speicher (S2) sowie die dem Prüfling (P) zugeordnete Eingabe-/Ausgabeeinheit (EA2) anschliessbar sind, welche Eingabe-/Ausgabeeinheit (EA2) durch den Rechner (R) steuerbart ist, und dass eine durch den Rechner (R) steuerbare Bustrenneinrichtung (BT) das erste Bussystem (ACD) mit dem zweiten Bussystem (A'C'D') verbindet.

2. Schaltungsanordnung nach Anspruch 1, dadurch gekennzeichnet, dass die Bustrenneinrichtung (BT) Bustreiber (T1, T2, T3) aufweisende Durchschalteelemente umfasst.

3. Schaltungsanordnung nach Anspruch 1, dadurch gekennzeichnet, dass die Bustrenneinrichtung (BT) mindestens einen Datenbustreiber (T2) umfasst, dessen Steuereingang (E) mit dem Ausgangssignal einer UND-Verknüpfung (G1) beaufschlagt wird, deren erster Eingang über eine Steuerleitung (f1) mit dem Rechner (R) und deren zweiter Eingang mit dem Ausgang einer ODER-Verknüpfung (G2) verbunden ist, welche eingangsseitig an die zur Uebertragung von Schreib- und Lesebefehlen dienenden Leitungen (C1', C2') eines Steuerbusses (C') des zweiten Bussystems (A', C', D') angeschlossen ist.

## Claims

1. A circuit arrangement for testing electrical, in particular electronic devices, with a computer (R) which, on the basis of a test programme, produces test words which are fed to the object (P) to be tested, where the signals emitted from the object (P) to be tested are fed via an input/output unit to the computer (R) for purposes of analysis, and with a bus system (ACD) which is connected both to the computer (R) and to a store (S1), characterised in that a further input/output unit (EA1), which is connected to one or more than one peripheral device, can be connected to this bus system (ACD), that moreover a second bus system (A'C'D') is provided which can be connected to a second store (S2) and to the input/output unit (EA2) which is assigned to the object (P) to be tested, where said input/output unit (EA2) can be controlled by the computer (R), and that a bus decoupling device (BT) which can be controlled by the computer (R) connects the first bus system (ACD) to the second bus system (A'C'D').

2. A circuit arrangement as claimed in Claim 1, characterised in that the bus decoupling device (BT) comprises switch-through elements which include bus drivers (T1, T2, T3).

3. A circuit arrangement as claimed in Claim 1, characterised in that the bus decoupling device (BT) includes at least one data bus driver (T2) whose control input (E) is acted upon by the output signal of an AND logic link (G1), whose first input is connected via a control line (f1) to the computer (R) and whose second input is connected to the output of an OR logic link (G2) which is connected at its input end to those lines (C1', C2') of a control bus (C') of the second bus system (A', C', D') which serve to transmit write- and read-commands.

## Revendications

1. Montage pour tester des appareils électriques, notamment des appareils électroniques, comportant un calculateur (R) qui produit, sur la base d'un programme de contrôle, des mots de contrôle qui sont envoyés à l'appareil à tester (P), les signaux délivrés par l'appareil à tester (P) étant envoyés à des fins d'exploitation au calculateur (R) par l'intermédiaire d'une unité d'entrée/sortie, et comportant un système de bus (ACD) auquel sont raccordés le calculateur (R) ainsi qu'une mémoire (S1), caractérisé par le fait qu'une autre unité d'entrée/sortie (EA1) reliée à un ou plusieurs appareils périphériques peut être raccordée à ce système de bus (ACD), qu'il est prévu en outre un second système de bus (A', C', D'), auquel peuvent être raccordées une seconde mémoire (S2) ainsi que l'unité d'entrée/sortie (EA2) associée à l'appareil à tester (P) et qui peut être commandée par le calculateur (R), et qu'un dispositif (BT) de séparation des bus, qui peut être commandé par le calculateur (R), relie le premier système de bus (ACD) au second système de bus (A', C', D').

2. Montage suivant la revendication 1, caractérisé par le fait que le dispositif (BT) de séparation des bus comprend des éléments d'interconnexion directe comportant des étages d'attaque de bus (T1, T2, T3).

3. Montage selon la revendication 1, caractérisé en ce que le dispositif (BT) de séparation des bus comporte au moins un étage d'attaque de bus de transmission de données (T2), dont l'entrée de commande (E) est chargée par un signal de sortie d'un circuit ET (G1), dont la première entrée est reliée par l'intermédiaire d'une ligne de commande (f1) au calculateur (R) et dont la seconde entrée est reliée à la sortie d'un circuit ou (G2), dont le côté entrée est raccordé aux lignes (C1', C2'), servant à transmettre des instructions d'enregistrement et de lecture d'un bus de commande (C') du second système de bus (A', C', D').

FIG.1

FIG. 2